# FASCICULE DE BREVET EUROPEEN

(11) **EP 0 393 774 B1**
(45) Date de publication et mention de la délivrance du brevet: **05.04.1995**
(21) Numéro de dépôt: 90200924.0
(22) Date de dépôt: 13.04.1990
(51) Int. Cl.: H03K 17/78, H03K 17/94, G07C 9/00

(54) **Circuit de veille et dispositif de transmission de données muni d'un tel circuit**
Überwachungsschaltung und mit einer solchen Schaltung ausgerüstete Datenübertragungseinrichtung
Circuit and data transmission device containing such activation

(30) Priorité: 18.04.1989 FR 8905122
(43) Date de publication de la demande: 24.10.1990
(73) Titulaire: LABORATOIRES D'ELECTRONIQUE PHILIPS, 94450 Limeil-Brévannes (FR); Philips Electronics N.V., 5621 BA Eindhoven (NL)
(72) Inventeur: Steers, Michel, F-75007 Paris (FR); Hazan, Jean-Pierre, F-75007 Paris (FR); Delmas, Gilles, F-75007 Paris (FR); Courdille, Michel, F-75007 Paris (FR); Zaaijer, Gerrit, F-75007 Paris (FR)
(74) Mandataire: Landousy, Christian

(56) Documents cités:
- GB-A- 2 192 665
- US-A- 4 297 594
- ELEKTOR juillet/aout 1982, pages 7-89, RFA; G. KLEINNIBBELINK: "Solarzellen-Tochterblitz"

## Description

L'invention concerne un circuit de veille destiné à contrôler la mise en fonctionnement d'un dispositif de transmission de données. Elle concerne également le dispositif lui-même.

Dans beaucoup de situations la consommation en énergie électrique d'un dispositif de transmission de données doit être réduite à la période de temps strictement nécessaire à son utilisation. En dehors de cette période, le dispositif est inactif. Il est donc nécessaire qu'un circuit de veille puisse tester en permanence à quel instant le dispositif doit être replacé dans un état actif. Le circuit de veille par lui-même doit également avoir comme caractéristique essentielle d'être toujours en éveil et néanmoins consommer le moins d'énergie possible.

Le problème posé est donc de disposer d'un circuit de veille qui puisse être en permanence en état de recevoir et de se déclencher sur un message venant de l'extérieur, de disposer d'une grande immunité vis à vis dudéclenchement intempestif, et ceci en consommant la plus faible quantité d'énergie électrique.

Les nécessités de consommation très faibles sont particulièrement cruciales dans les dispositifs de transmission alimentés par une source d'énergie électrique autonome. Il s'agit le plus souvent de dispositifs portatifs alimentés par des batteries.

Les nécessités de déclenchement à distance correspondent à une autre approche, soit par exemple que le dispositif à déclencher soit difficilement accessible directement, soit qu'un objectif de synchronisation soit recherché.

Dans cette dernière catégorie se trouve le document intitulé :
"Déclenchement photovoltaïque par flash esclave" par G. KLEINNIBBELINK dans Elektor 7/8 - 1982 page 86.

Le circuit de veille qui y est décrit est destiné en photographie à déclencher un flash esclave en synchronisme avec un flash maître. Le déclenchement est assuré par le flash maître à l'aide de la lumière émise. Un tel circuit de veille possède une consommation faible. Il est prévu pour opérer à très bref délai dans des conditions d'éclairement et de délai déterminés par le flash maître. Il présente certains inconvénients, qui sont détaillés plus loin, qui le rendent inapte à servir de circuit de veille opérant sous des conditions d'éclairement multiples notamment vis à vis des déclenchements intempestifs.

D'autre part étant donné les durées de vie envisagées (un an environ) et le nombre de communications entre un système interrogateur et le circuit de veille, il n'est pas question de faire fonctionner en permanence l'électronique commandée par le circuit de veille avec une consommation qui dépasserait quelques microampères (avec un fonctionnement sur pile, par exemple 6 volts). Il est donc nécessaire de disposer d'un circuit de veille consommant peu ou pas, qui n'active l'électronique commandée que sur interrogation du système interrogateur de surveillance et qui remet cette électronique en état de veille après interrogation.

Pour cela l'invention est remarquable en ce que le circuit de veille comprend un thyristor avec une gâchette et un circuit en boucle formé d'une self et d'un générateur d'énergie électrique produite par un événement lumineux, le circuit en boucle contrôlant l'état de conduction-blocage du thyristor par le fait que la gâchette du thyristor est reliée à une borne du générateur ayant une polarité bloquant le thyristor lorsque le générateur est dans un état stationnaire d'éclairement, le thyristor étant débloqué par une rupture brusque de l'événement lumineux grâce à une énergie restituée par la self, la self alors appliquant à la gâchette l'énergie électrique ayant une polarité inverse de la précédente et suffisante pour débloquer le thyristor.

Avantageusement l'invention peut opérer sans être perturbée par l'éclairement ambiant même s'il est intense et ceci en ne consommant pratiquement rien à l'état de veille.

Le circuit de veille selon l'invention est plus particulièrement destiné à contrôler l'alimentation en énergie électrique d'un badge muni d'un dispositif de transmission. Le badge sert à contrôler une personne et à l'autoriser à franchir un périmètre donné.

L'événement lumineux peut être constitué par une impulsion de lumière. Ceci permet avantageusement d'interroger très rapidement le circuit de veille ce qui permet une suite d'opérations à cadence élevée lorsque des circuits de veille différents doivent être interrogés. L'impulsion peut se situer dans l'infrarouge. Avantageusement ceci permet d'éviter l'éblouissement du porteur de badge et de se prémunir vis à vis d'autres impulsions lumineuses lorsque par exemple le circuit de veille doit être interrogé dans une ambiance où par exemple opèrent des flashes d'appareils photographiques.

Le circuit selon l'invention est extrèmement fiable, sensible et de consommation négligeable en veille (inférieur à 1 microampère). Le circuit de veille est déclenché par une impulsion lumineuse créée par un flash électronique déclenché par le système interrogateur de surveillance à l'approche de la personne. Elle est elle-même détectée par un système infrarouge passif ou une barrière optique pour mettre en marche le système interrogateur. Cette impulsion de lumière est captée par le badge par l'intermédiaire de cellules photovoltaïques. En plus de renseignements écrits tels que le nom de la personne et différentes identifications, le badge peut comprendre un dispositif de transmission destiné à communiquer avec le monde extérieur. Ce dispositif va pouvoir détecter l'impulsion lumineuse à l'aide du circuit de veille, recevoir et décoder les données d'interrogation issues du système interrogateur de surveillance et coder et émettre en retour des données permettant d'identifier le porteur du badge. Ces données sont stockées dans une unité de stockage. Un boîtier amovible peut contenir l'unité de stockage seule ou associée à l'unité de décodage/codage. Il peut présenter des renseignements d'identification. Le boîtier amovible peut être un support plat de carte électronique à mémoire. Le boîtier peut contenir également l'ensemble du dispositif de transmission qui permet d'interroger, de lire et de transmettre les données codées stockées dans l'unité de stockage.

Le dispositif comprend :
- un récepteur/émetteur de lumière qui reçoit/émet des informations lumineuses codées d'entrée/sortie,
- un processeur de traitement qui comprend :
   . une unité de décodage/codage des données d'entrée/sortie,
   . une unité de stockage de données qui sont codées puis transmises par l'unité de décodage/codage,
- des moyens d'alimentation du récepteur/émetteur et du processeur de traitement,
- et un circuit de veille qui contrôle le fonctionnement desdits moyens d'alimentation.

L'invention sera mieux comprise à l'aide des figures suivantes données à titre d'exemple non limitatif qui représentent :
figure 1 : un schéma d'un circuit de déclenchement utilisé en photographie selon l'art antérieur,
figures 2A, 2B, 2C, 2D : des représentations schématiques des variations de courant dans le circuit en boucle muni ou non de la self,
figure 3 : un circuit de veille selon l'invention,
figure 4 : une représentation des variations de courant dans le circuit en boucle selon l'invention,
figure 5 : un schéma électrique du circuit de veille selon l'invention muni de moyens pour désactiver le thyristor après une durée prédéterminée,
figure 6 : une représentation d'un dispositif qui incorpore l'invention.

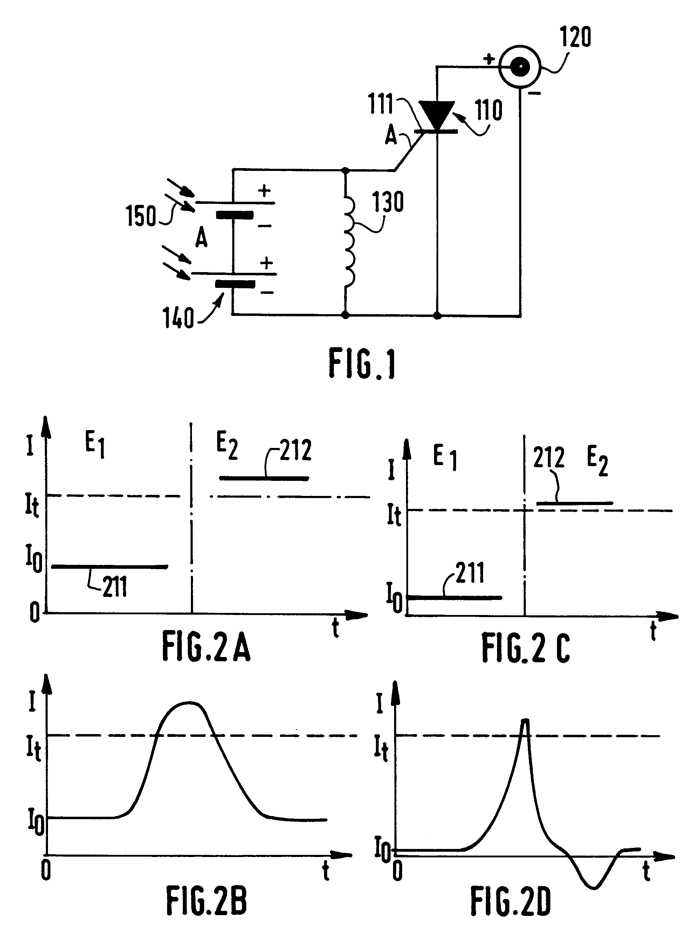

Sur la figure 1 est représenté selon l'art antérieur un thyristor 110 qui contrôle la mise en fonctionnement d'une source d'énergie électrique 120. La gâchette 111 du thyristor est réunie à un circuit en boucle qui est constitué par une self 130 et une batterie de cellules solaires 140. Sur ce schéma le thyristor est de type PNPN et la gâchette est réunie au pôle positif de la batterie de cellules solaires 140. Celles-ci sous l'influence d'un rayonnement lumineux 150 génère une énergie électrique suffisante pour dépasser le seuil d'amorçage du thyristor et placer celui-ci en état de conduction. La source d'énergie électrique 120 est alors mise en fonctionnement et peut débiter dans la charge prévue à cet effet.

Le mécanisme de fonctionnement est représenté sur les figures 2A à 2D.

Les figures 2A et 2B se rapportent à ce qui se produirait si le circuit de veille ne disposait pas de self 130. Sur la figure 2A pour un éclairement ambiant E₁ faible le courant I₀ débité dans le circuit en boucle est très faible (état 211). Lorsque l'éclairement ambiant croît (état E₂), le courant croît (état 212) et peut passer le seuil Iₜ qui permet d'atteindre au point A sur la gâchette (fig. 1) une tension suffisante pour laquelle le thyristor se met en conduction. Si l'éclairement est produit par une impulsion lumineuse (figure 2B) le seuil de courant Iₜ est dépassé pendant une durée qui dépend de la longueur de l'impulsion lumineuse.

Les figures 2C et 2D concernent le cas où la self 130 est placée dans le circuit de veille (figure 1). Cette self a nécessairement une résistance R non nulle. Dans ce cas, pour les mêmes éclairements ambiants E₁ et E₂, les états 211 et 212 se rapportent à un courant de boucle plus faible. Le seuil Iₜ peut encore être franchi. En présense d'une impulsion lumineuse la durée de conduction du thyristor devient plus étroite, le seuil Iₜ est dépassé pendant un temps beaucoup plus court que précédemment et la position temporelle du déclenchement est déterminée avec beaucoup plus de précision grâce à l'action de filtrage de la self. C'est cette raison qui fait que le circuit de la figure 1 est intéressant pour des applications photographiques où c'est la précision temporelle et la synchronisation de plusieurs flashes qui est déterminante.

Ainsi dans ce montage le thyristor devient passant dès qu'un seuil de lumière suffisant, même continu, est reçu par le récepteur. Pour limiter ce risque l'art antérieur propose d'opérer en ambiance peu lumineuse avec la self montée en parallèle avec la cellule solaire. Avec un tel circuit, en ambiance lumineuse naturelle, dans laquelle le porteur de badge peut fréquemment se trouver, il peut apparaître une tension résiduelle suffisante pour déclencher intempestivement le thyristor. Ce montage est inutilement sollicité dans un tel mode opératoire.

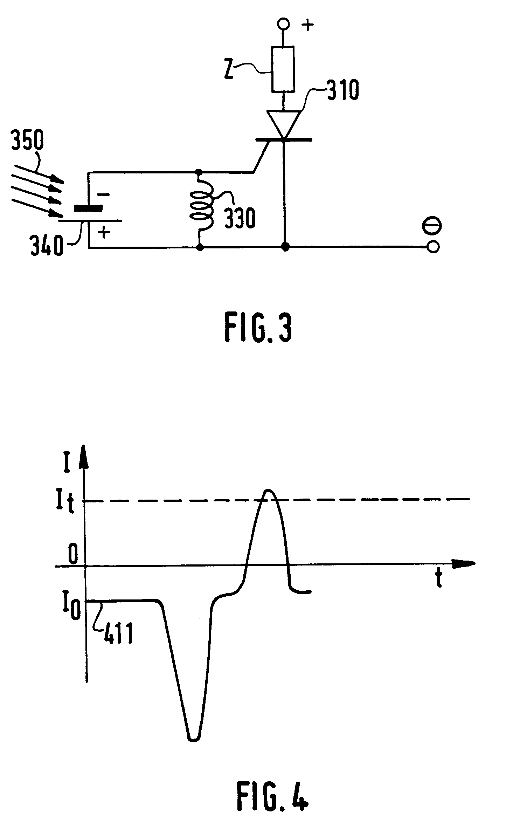

Sur la figure 3, selon l'invention est représenté un thyristor PNPN 310 par exemple 2N5062 dont la gâchette est reliée au pôle négatif du générateur d'énergie électrique 340 qui reçoit l'impulsion lumineuse 350. Aux bornes de ce générateur électrique est placée une self 330 par exemple de 10 mH. Le thyristor 310 est relié à la source d'alimentation à travers la charge Z.

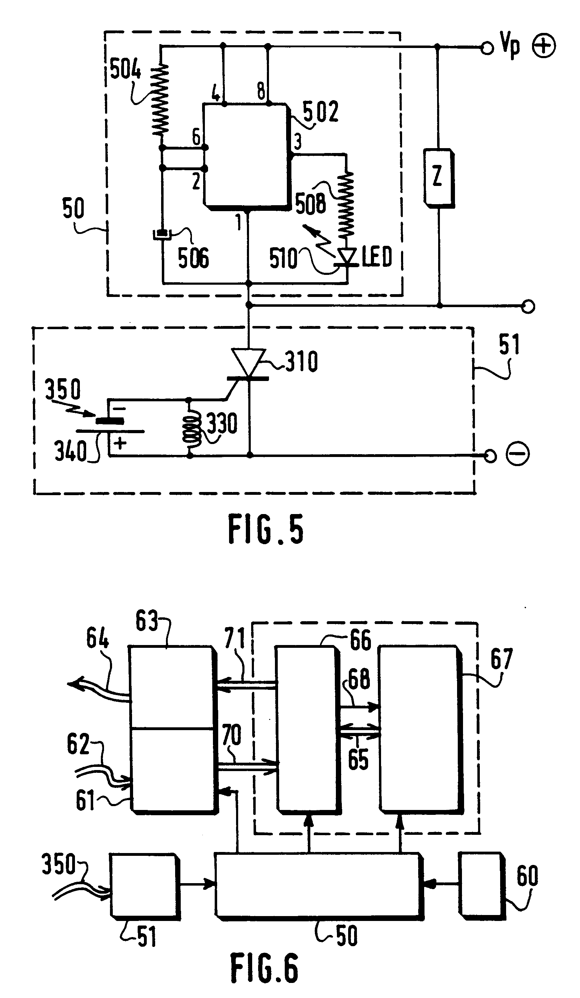

Le fonctionnement de ce circuit de veille est représenté sur la figure 4. Pour un éclairement ambiant (état 411) le sens du courant électrique dans la boucle est inverse du cas précédent. En présence de l'impulsion lumineuse, la tension croit en valeur absolue mais avec la polarité qui bloque encore plus la gâchette du thyristor. Lorsque l'impulsion lumineuse a cessé, la self 330 restitue l'énergie électrique stockée au cours de ladite impulsion lumineuse sous la forme d'un courant de restitution inverse du courant précédent. Il apparaît ainsi un courant Iₜ avec la bonne polarité suffisant pour développer aux bornes de la self une tension suffisante pour dépasser la tension de seuil et ainsi déclencher le thyristor. Ce n'est donc pas au moment de l'impulsion lumineuse que le thyristor est débloqué, mais plus tard au cours de la restitution d'énergie. Le circuit est d'autant plus sensible que la variation de l'événement lumineux a été rapide. On a obtenu un fonctionnement correct avec une self de 10 mH ayant une résistance de R=100 ohms avec une durée de rupture de l'événement lumineux de 1 microseconde environ. On obtient ainsi une grande immunité à la lumière ambiante qui peut provenir de la lumière naturelle ou de la lumière artificielle émise par des sources auxiliaires.

Il est possible de sélectionner les caractéristiques de l'impulsion lumineuse, par exemple sa longueur d'onde ou sa durée. En opérant en infrarouge on peut ainsi rendre plus sélectif le fonctionnement du circuit de veille.

Lorsque le circuit de veille a été réveillé par une telle impulsion lumineuse pour mettre en fonctionnement le badge ou tout circuit qu'il permet de contrôler, il est nécessaire de le replacer le plus vite possible dans l'état de veille afin de limiter au maximum la consommation d'énergie issue de la source alimentant le badge ou le circuit. Cela peut être fait à l'aide de données codées qui sont fournies au badge. Cela peut également être fait à l'aide d'un circuit de temporisation par exemple le circuit 50 représenté sur la figure 5.

La figure 5 représente un schéma électrique du circuit de veille 51 et du circuit de temporisation 50 opérant avec une charge Z. Le circuit de temporisation est par exemple un monostable 502 du type EXAR L555. Sa constante de temps peut être réglée par une résistance 504 et une capacité 506. Le circuit est réuni (bornes 4 et 8) au pôle positif VP de la batterie et au pôle négatif de la batterie à travers le thyristor du circuit de veille 51. Une résistance 508 et une diode émettrice LED 510 permettent de signaler l'état de la temporisation et d'avertir l'utilisateur de l'état de veille. Le circuit peut par exemple une seconde après le déclenchement du thyristor diminuer fortement l'intensité du courant qui circule et bloquer ainsi le thyristor.

L'invention a été décrite avec un thyristor de type PNPN. Il est bien sûr possible d'utiliser des thyristors du type NPNP en inversant les polarités décrites.

Une représentation schématique de l'ensemble du badge est réprésentée sur la figure 6. Il comprend un circuit de veille 51 réuni par le circuit de temporisation 50 à une batterie 60. Le circuit de temporisation permet de contrôler l'alimentation :
- d'un récepteur de lumière 61 qui reçoit des données codées préférentiellement sous forme d'un faisceau infrarouge 62,
- d'un émetteur de lumière 63 qui émet des données codées préférentiellement sous forme d'un faisceau infrarouge 64,
- d'une unité de décodage/codage 66 qui traite les données relatives à l'émetteur et au récepteur (bus 70 et 71)
- d'une unité de stockage 67 de données qui transfère ses données sur le bus 65 à l'unité 66 sous le contrôle de la commande d'appel 68.

La sensibilité du dispositif est très bonne. Un déclenchement par impulsion lumineuse est possible à plusieurs mètres. La sensibilité peut d'ailleurs être ajustée par la valeur de la self ou le nombre de cellules solaires. On peut notamment limiter ainsi le rayon d'action à la distance désirée et éviter des déclenchements intempestifs (flashes de photographes, interrogation d'une personne à la fois). Afin de ne pas gêner la personne porteuse du badge, un filtre infrarouge est placé sur le flash émetteur rendant invisible pour l'oeil l'impulsion de lumière.

Soit l'unité de stockage 67 seule, soit l'unité de stockage 67 et l'unité de décodage/codage 66 peuvent être placées dans un boîtier amovible. Ce boîtier peut recevoir en outre différentes indications écrites ou d'identification (photo) qui permettent facilement de le personnaliser. Ce boîtier peut par exemple être un support plat de carte électronique à mémoire.

## Revendications

1. Circuit de veille comprenant un thyristor avec une gâchette et un circuit en boucle formé d'une self et d'un générateur d'énergie électrique produite par un événement lumineux, le circuit en boucle contrôlant l'état de conduction-blocage du thyristor par le fait que la gâchette du thyristor est reliée à une borne du générateur ayant une polarité bloquant le thyristor lorsque le générateur est dans un état stationnaire d'éclairement, le thyristor étant débloqué par une rupture brusque de l'événement lumineux grâce à une énergie restituée par la self, la self alors appliquant à la gâchette l'énergie électrique ayant une polarité inverse de la précédente et suffisante pour débloquer le thyristor.

2. Circuit de veille selon la revendication 1 caractérisé en ce que l'événement lumineux est constitué par une impulsion de lumière.

3. Circuit de veille selon une des revendications 1 ou 2 caractérisé en ce que l'événement lumineux se situe dans l'infrarouge.

4. Circuit de veille selon une des revendications 1 à 3 caractérisé en ce qu'il comprend des moyens pour désactiver le thyristor après une durée prédéterminée.

5. Dispositif de transmission de données caractérisé en ce qu'il comprend :
- un récepteur/émetteur de lumière qui reçoit/émet des informations lumineuses codées d'entrée/sortie,
- un processeur de traitement qui comprend :
. une unité de décodage/codage des données d'entrée/sortie,
. une unité de stockage de données qui sont codées puis transmises par l'unité de décodage/codage,
- des moyens d'alimentation du récepteur/émetteur et du processeur de traitement,
- et un circuit de veille selon une des revendications 1 à 4 qui contrôle le fonctionnement desdits moyens d'alimentation.

6. Dispositif selon la revendication 5 caractérisé en ce que l'unité de décodage/codage désactive le thyristor à partir des données codées reçues.

7. Dispositif selon une des revendications 5 ou 6 caractérisé en ce que l'unité de stockage est placée dans un boîtier amovible.

8. Dispositif selon une des revendications 5 ou 6 caractérisé en ce que l'unité de stockage et l'unité de décodage/codage sont placées dans un boîtier amovible.

9. Dispositif selon les revendications 7 ou 8 caractérisé en ce que le boîtier amovible est un support plat de carte électronique à mémoire.

## Patentansprüche

1. Steuerschaltung mit einem Thyristor mit einer Trigger-Gate und einer Rückkopplungsschaltung mit einer Induktivität und einem Generator zum Erzeugen von elektrischer Energie in Antwort auf ein Lichtereignis, wobei die Rückkopplungsschaltung imstande ist, den leitenden oder gesperrten Zustand des Thyristors zu steuern und zwar durch die Tatsache, daß die Trigger-Gate des Thyristors mit einem Anschluß des Generators verbunden ist, der eine Polarität hat, die den Thyristor abschaltet, wenn der Generator in einem statischen Beleuchtungszustand ist, wobei die Rückkopplungsschaltung dazu vorgesehen ist, den Thyristor in Antwort auf diejenige Energie einzuschalten, die durch die Induktivität restituiert wird, wobei die Energie durch eine plötzliche Unterbrechung des leuchtenden Ereignisses verursacht wird und die Induktivität dadurch elektrische Energie triggert mit einer Polarität, welche die umgekehrte Polarität der vorhergehenden Polarität ist und ausreicht um den Thyristor zu einzuschalten.

2. Steuerschaltung nach Anspruch 1, dadurch gekennzeichnet, daß der Generator in Antwort auf einen Lichtimpuls elektrische Energie erzeugt.

3. Steuerschaltung nach Anspruch 1, dadurch gekennzeichnet, daß der Generator in Antwort auf einen Lichtimpuls innerhalb des IR-Bereiches elektrische Energie erzeugt.

4. Steuerschaltung nach Anspruch 1, 2 oder 3, dadurch gekennzeichnet, daß sie Mittel aufweist, den Thyristor nach der vorbestimmten Periode abzuschalten.

5. Datenübertragungsanordnung , dadurch gekennzeichnet, daß diese die nachfolgenden Elemente aufweist:
einen Lichtempfänger/Sender, der Information empfängt/codierte Eingangs-/Ausgangslichtinformation aussendet,
einen Verarbeitungsprozessor, der die folgenden Elemente aufweist:
eine Einheit zum Decodieren/Codieren von Eingangs-/Ausgangsdaten,
eine Einheit zur Speicherung von Daten, die codiert und danach durch die Decodierungs/Codierungseinheit übertragen sind,
Mittel zur Speisung des Empfängers/Senders und des Verarbeitungsprozessors,
und eine Steuerschaltung nach Anspruch 1, 2, 3 oder 4, welche die Wirkung der genannten Speisemittel steuert.

6. Anordnung nach Anspruch 5, dadurch gekennzeichnet, daß die Codierungs-/Decodierungsanordnung aufgrund der empfangenen codierten Daten den Thyristor abschaltet.

7. Anordnung nach einem der Ansprüche 5 oder 6, dadurch gekennzeichnet, daß die Speichereinheit in einem entfernbaren Gehäuse untergebracht ist.

8. Anordnung nach Anspruch 5 oder 6, dadurch gekennzeichnet, daß die Speichereinheit und die Decodierungs-/Codierungseinheit in einem entfernbaren Gehäuse untergebracht sind.

9. Anordnung nach Anspruch 7 oder 8, dadurch gekennzeichnet, daß das entfernbare Gehäuse ein flacher Träger für eine elektronische Speicherplatte ist.

## Claims

1. A control circuit comprising a thyristor having a gate and a loop circuit comprising an inductance and a generator for producing electric power in response to a luminous event, the loop circuit controlling the on-state/off-state of the thyristor in that the gate of the thyristor is coupled to a terminal of the generator having a polarity which turns off the thyristor when the generator is in a steady state of illumination, the thyristor being turned on by power returned by the inductance in response to a sudden interruption of the luminous, the inductance then supplying the gate with electric power of a polarity which is the inverse of the previous polarity and adequate to turn on the thyristor.

2. A control circuit as claimed in Claim 1, characterised in that the luminous event is a light pulse.

3. A control circuit as claimed in Claim 1, characterised in that the luminous event is situated in the infrared range.

4. A control circuit as claimed in Claim 1, 2 or 3, characterised in that it comprises means for turning off the thyristor after a predetermined time.

5. A data transmission device, characterised in that it comprises:
- a light receiver/transmitter which receives/transmits encoded input/output light information,
- a processor which comprises:
. a decoding/encoding unit for input/output data,
. a unit for the storage of data which is encoded and subsequently transmitted by the decoding/encoding unit,
- means for the power supply of the receiver/transmitter and the processor, and
- a control circuit as claimed in any one of the Claims 1 to 4, which controls the operation of said power-supply means.

6. A device as claimed in Claim 5, characterised in that the encoding/decoding unit turns off the thyristor on the basis of received encoded data.

7. A device as claimed in Claim 5 or 6, characterised in that the storage unit is accommodated in a removable case.

8. A device as claimed in Claim 5 or 6, characterised in that the storage unit and the decoding/encoding unit are accommodated in a removable case.

9. A device as claimed in Claim 7 or 8, characterised in that the removable case is a flat support for an electronic memory card.
